# EUROPEAN PATENT APPLICATION

(11) **EP 4 187 594 A1**
(43) Date of publication of application: **31.05.2023**
(21) Application number: 21210786.6
(22) Date of filing: 26.11.2021
(51) Int. Cl.: H01L 23/498, H01L 21/48, H01L 23/373

(54) **METAL SUBSTRATE STRUCTURE AND METHOD OF ATTACHING A TERMINAL TO A METAL SUBSTRATE STRUCTURE FOR A SEMICONDUCTOR POWER MODULE AND SEMICONDUCTOR POWER MODULE**

(71) Applicant: Hitachi Energy Switzerland AG, 5400 Baden (CH)
(72) Inventor: Guillon, David, 8857 Vorderthal (CH); Bayer, Martin, 5036 Oberentfelden (CH); Roesch, Andreas, 79730 Murg (DE); Salvatore, Giovanni, 34170 Gorizia (IT)
(74) Representative: Epping - Hermann - Fischer

(57) **Abstract**

A method for attaching a terminal (4) to a metal substrate structure (3) for a semiconductor power module (10) comprises providing at least one terminal (4) and providing the metal substrate structure (3) with a metal top layer (17), a metal bottom layer (19) and an isolating resin layer (18) arranged between the metal top layer (17) and the metal bottom layer (19). The method further comprises coupling the at least one terminal (4) to the metal top layer (17) of the metal substrate structure (3) by means of laser welding with a laser beam (6).

## Description

The present disclosure is related to a method for attaching a terminal to a metal substrate structure for a semiconductor power module with an isolating resin sheet. The present disclosure is further related a semiconductor power module for a semiconductor device. The present disclosure is further related to a corresponding metal substrate structure.

Conventional insulated metal substrates form technology for low and medium power semiconductor packages with low insulation requirements and low thermal resistance requirements simultaneously. Terminals are prepared on the insulated metal substrate and there is a need for a reliable connection of the terminals on the insulated metal substrate.

Embodiments of the present disclosure relate to a method for attaching a terminal to a metal substrate structure that can contribute to a cost saving metal substrate structure for a semiconductor power module which enables reliable functioning even for high voltage power module applications. Further embodiments of the present disclosure relate to a corresponding metal substrate structure and semiconductor power module for a semiconductor device.

According to an embodiment, a method for attaching a terminal to a metal substrate structure for a semiconductor power module comprises providing at least one terminal and providing the metal substrate structure (3) with a metal top layer, a metal bottom layer and an isolating resin layer arranged between the metal top layer and the metal bottom layer. The method further comprises coupling the at least one terminal to the metal top layer of the metal substrate structure by means of laser welding with a laser beam.

Due to the described method realization of laser welded joining connections on an insulated metal substrate are possible which can contribute to a stable and reliable functioning of a semiconductor power module even for high voltage power module applications. The method contributes to secure attachment of terminals on insulated metal substrates by laser welding.

It is a recognition in connection with the present disclosure that conventional insulated metal substrates realize technologies for low and medium power semiconductor packages with low insulation requirements and low thermal resistance requirements simultaneously. For low reliability requirements, terminals can be e.g. soldered or glued on substrate. Usually, welding provides better reliability, but a welding process can be critical for the substrate structure. In view of conventional setups of such insulated metal substrates corresponding terminals are connected to a top metallization using welding techniques to provide typically joining connections which can be critical with respect to a stable process on the substrates and a resin isolation sheet below the metallization. The welding process can lead to damages of the substrate structure and especially ultrasonic welding provides a strong impact of thermal and mechanical stress combined with heat on the substrate structure due to friction and pressure between a terminal foot and the substrate. Here a resin sheet is strongly endangered by deformation and crack formation. Corresponding failure modes must be considered when applying ultrasonic welding of terminal feet on a circuit metallization of an insulated metal substrate.

By use of the described method for manufacturing a metal substrate structure it is possible to counteract the aforementioned adverse effects due to the laser welding process. A risk of crack or damage formation in the resin layer can be reduced and a stable semiconductor power module is feasible that enables reliable functioning even for high voltage power module applications in a voltage range of 0.5 kV up to 10.0 kV, for example. The one or more terminals can be welded directly onto the metal top layer to form a direct copper-to-copper contact, for example. Alternatively to a direct contact, an additional spacer element can be located between a bottom surface of the terminal and an upper or top surface of the metal top layer facing each other.

The resin layer forms a dielectric layer and can be realized as a pre-preg sheet which is assembled between two metal plates on top and bottom forming the metal top layer and the metal bottom layer. Such metallization sheets or plates are bonded to the insulation of the dielectric resin layer by the lamination process, for example. A required metallization structure of the metal top layer can then be done by subsequent steps of masking and etching processes to locally remove conductive metal, creating the final metallization structure. Alternatively, the top metallization structure can be formed by cutting or stamping, for example before the formation of the finished metal substrate structure.

Alternatively, the resin layer can be formed by molding. With respect to such a molded dielectric layer, a molding substance realizes a pumpable substance with predetermined material properties. The pumpable substance is a liquid or viscous raw material of the resin layer to be formed. For example, the molding substance is an epoxy and/or ceramic based liquid. Alternatively or additionally, the raw material of the dielectric layer may be a thermosetting or a thermoplastic resin material such as polyamide, PBT, PET. Alternatively or additionally, the raw material of the dielectric layer may comprise inorganic filler for improved thermal conductivity and/or CTE adjustment with respect to the metal top layer and/or the metal bottom layer. For example, the molded dielectric layer comprises a resin based dielectric material with ceramic filling material, e.g. Al2O3, AlN, BN, Si3N4 or SiO2. For example, the dielectric layer is an epoxy with filler. The dielectric layer can be also based on other materials suitable for transfer, injection or compression molding or other applicable molding technologies such as bismaleimide, cyanate ester, polyimide and/or silicones. Alternatively or additionally, the dielectric layer can include a ceramic material and/or hydroset material or a material combination of two or more of the aforementioned components.

The aligning of the metal top layer and the metal bottom layer relative to each other with a predetermined distance in between will substantially predetermine the later thickness of the molded dielectric layer. For example, the thickness is defined along a stacking direction of the metal substrate structure which may present a z-direction. However, the alignment can also be done in the perpendicular x- and y-directions for proper positioning, e.g. of the metal pattern with respect to the x- and y-direction. For example, the alignment can be realized by placing the metal top layer onto a release film or liner or another fixation, for example in a mold chase of a molding tool. This enables to precisely position the provided metallization structure of the metal top layer relative to the metal bottom layer and can be useful if the metal top layer comprises separate metal pads due to different potentials of operation, for example. In case of lamination, a thickness of a resin layer is given by the thickness and the behavior of the laminated layer.

According to an embodiment of the method the at least one terminal is provided with one or more coatings that partially or completely covers a predetermined surface of the respective terminal. The terminal can comprise an anti-reflection coating on a top surface that is configured to face the impinging laser beam during laser welding. An efficiency of the irradiation with the laser beam can be improved by an anti-reflecting coating that is arranged on the top side of a terminal foot, for example. Alternatively or additionally, the terminal can comprise a coating, for example made from noble metal such as silver or gold, on a bottom surface that is configured to face the metal top layer of the metal substrate structure during laser welding, for example for prevention of oxidation or for an improved laser welding process.

According to a further embodiment of the method, the laser parameters of the laser beam can be given to beneficially affect the laser welding. Thus, the laser beam or a corresponding laser source used for laser welding can be configured to provide a power of 300 - 3000 W. Alternatively or additionally, the laser beam or the laser source for laser welding can be configured to provide a traveling speed of 1-200 mm/s guided along a top surface of the at least one terminal that faces the impinging laser beam. Thus, the welding does not have to be done only at one limited point and the laser spot of the laser beam providing the welding process can be moved with an aforementioned velocity to provide a joining connection over a defined area.

The laser beam can also be configured to oscillate with a predetermined frequency. Thus, the laser spot position can oscillate or wobble with a frequency of up to 2 kHz to beneficially affect the welding process.

According to a further embodiment of the method the step of coupling the at least one terminal to the metal substrate structure by means of laser welding comprises aligning the terminal and the metal substrate structure relative to each other such that a top surface of the metal top layer contacts a bottom surface of the terminal facing each other. The method further comprises laser welding the terminal with the laser beam such that a welding joint between the terminal and the metal substrate structure is formed and the at least one terminal and the metal top layer are firmly bonded.

According to a further embodiment of the method the terminal and the metal substrate structure are aligned relative to each other with a predetermined distance in between defining a gap of up to 500 µm between a top surface of the metal top layer and a bottom surface of the terminal facing each other. Laser welding the terminal with the laser beam is done such that the terminal locally melts and a welding joint between the terminal and the metal substrate structure is formed by means of dropping or running or deformation of molten metal portion (held by surface tension) and the at least one terminal and the metal top layer are firmly bonded. Using such a configuration can realize an improved positioning of the terminal and a protection of the insulated metal substrate structure against heat achieved by the formation of the small gap of maximum a few hundreds of microns between metal top layer and the terminal. The terminal may comprise an L-shape with a terminal body and a terminal foot and the terminal foot can be kept in position, whereas a laser welded joining connection is provided by drops or deformed portion of molten material from the terminal foot.

It is a recognition in connection with the present disclosure that despite of a situation being less critical compared with ultrasonic welding, also a laser welding process of copper terminals on the circuit metallization of the metal substrate structure formed by the metal top layer beneficially includes features to minimize the thermal impact on the heat sensitive isolating resin sheet or resin layer. On the one hand the thermal impact on the resin layer can be reduced by protective features providing a reduced heat flow into the resin layer. On the other hand the impact can be reduced additionally or alternatively by features resulting in a lower needed thermal effort for the realization of the laser welded terminal bond.

Thus, according to a further embodiment of the method the metal top layer is provided with at least one protrusion with a given local enhanced thickness that is up to 2.0 mm thicker than an adjacent area of the metal top layer. The protrusion is formed at a position on a top surface of the metal top layer that is configured to be coupled to the at least one terminal. The protrusions can be made from one piece with the metal top layer. Alternatively, the protrusions is formed by an additional element such as a piece of copper foil or sheet or block or the like.

Such an intentionally formed protrusion enables protection of the resin layer against thermal impact and may be formed in one piece with the circuit metallization having a locally larger thickness on the position of the terminal foot. The protrusion provides a longer thermal path between welding position and resin layer and a stronger lateral heat spreading in the substrate metallization, but also on a mechanical enforcement of the substrate. Alternatively or additionally, a separate spacer element can form a predetermined protrusion on the surface of the metal top layer.

According to a further embodiment the method comprises providing a metal spacer element configured to form a protrusion for the at least one terminal, and coupling the metal spacer element to the metal top layer of the metal substrate structure. The method further comprises coupling the at least one terminal to the metal spacer element by means of laser welding with a laser beam such that a welding joint between the terminal and the metal spacer element is formed and the at least one terminal and the metal spacer element are firmly bonded. The metal spacer element can be provided in form of a metal block or spring with a thickness of 0.5 mm up to 2.0 mm, for example. The thickness relates to a dimension along a stacking direction of the metal substrate structure and the at least one terminal and can also represent a height of the protrusion extending above the adjacent top surface of the metal top layer.

The implementation of an additional metal block or spring on the top surface of the metal substrate structure at the position, where the terminal foot is joined by laser welding, contributes to protection of the resin layer against thermal impact. The metal block or spring can be joined to the circuit metallization or the metal top layer by soldering, gluing, sintering, or any other suitable joining method.

According to a further embodiment of the method the metal spacer element is provided with a coating layer on a top surface that is configured to face a bottom surface of the at least one terminal during laser welding. The metal spacer element may be coated at its top surface completely or partially with a noble metal, such as silver or gold or nickel or other metals, for an improved joining process to the terminal. Alternatively or additionally, the metal spacer element may be coated at its bottom surface completely or partially with a noble metal for an improved joining process to the metal top layer.

According to a further embodiment of the method, the at least one terminal comprises a terminal foot that is configured to be coupled with the metal top layer and that comprises a structure prepared for improved laser welding. Such a welding structure can be realized by a thinned area, a slot, a groove and/or a recess in the terminal foot Alternatively or additionally, the complete terminal foot may be formed thinner than the main body of the terminal. For example, a range for the thickness of the thinned terminal food could be between 0.3 and 0.8 times the thickness of the terminal main body.

Such specific terminal structures can beneficially affect the laser welding process and can contribute to a reduction of heating power or energy impact of the laser irradiation by the laser beam on the terminal foot. Thus, one option is a reduction of the thickness of the terminal foot partially or completely. The complete terminal foot or at least a welding area of the terminal foot can be made thinner compared with adjacent sections, such as a vertical body section of the terminal. Alternatively, the terminal foot can be made locally thinner, e.g. by the implementation of one or more grooves, recessed parts and/or slots into the terminal foot.

The welding process is done on such thinner portions, so that the laser energy needed to realize a laser welded connection can be reduced due to lower amount of metal to be molten and a reduced lateral heat dissipation results.

The implementation of holes or slots into the terminal foot can enable a direct irradiation of the interface, the edges of the holes or slots in particular, for example in between the substrate metallization formed by the metal top layer and the terminal foot can be achieved, so that a lower amount of metal has to be molten to realize a laser welded joining connection. Additionally, a lateral heat spreading in the terminal foot may be prevented or reduced by holes, slots or grooves.

The terminal foot can be welded to the metal top layer or the metal spacer element such that the welding connection comprises multiple small local spots on the terminal foot to reduce the thermal impact during laser welding with sufficient pauses for cooling down between a preparation of single welding spots. Here the total heat energy might be not reduced, but the heat energy per spot and the pauses in the process facilitate sufficient heat dissipation and consequently less temperature rise in the resin layer. Moreover, the terminal foot can be designed specifically to beneficially affect the formation of multiple welding locations due to holes, slots and/or grooves prepared for welding, for example.

According to a further embodiment of the method the step of providing the metal substrate structure comprises providing the metal top layer, providing the metal bottom layer and providing a dielectric material in form of a molding substance. The method further comprises aligning the metal top layer and the metal bottom layer relative to each other with a predetermined distance in between, and bringing in the provided molding substance between the aligned metal top layer and the metal bottom layer and thereby forming the isolating resin layer by means molding, for example by means of injection molding, compression molding and/or transfer molding.

Moreover, according to an embodiment of the method the step of coupling the at least one terminal to the metal top layer by means of laser welding can be done beforehand the metal top layer is coupled to the resin layer and/or the metal bottom layer. Thus, the laser welding connection of the terminal and the metal top layer can be done and then the metal top layer is coupled with the dielectric resin layer and/or the metal bottom layer. In other words, the coupling of the metal top layer with the resin layer and/or the metal bottom layer is processed afterwards to the coupling of the terminal with the metal top layer by means of welding. Thus, mechanical stress due to coupling the terminals and/or thermal stress due to laser welding is kept away from the resin layer and contributes to avoid cracks or other damages of the resin layer.

By use of the described manufacturing or attaching method it is possible to counteract adverse effects by use of the laser welding process. Thus, a risk of crack or damage formation can be reduced and a stable semiconductor power module is feasible that enables reliable functioning of the semiconductor power module. The one or more terminals can be welded directly onto a surface of the metal top layer to form a direct copper-to-copper contact, for example. Alternatively, there can be a spacer element located between the bottom surface of the terminal and the upper surface or top surface of the metal top layer facing each other.

Finally, it is pointed out that all the proposed features and methods can be used solely, but also a combination of two or more.

According to an embodiment, a metal substrate structure for a semiconductor power module comprises a metal top layer, a metal bottom layer and an isolating resin layer that is coupled with both the metal top layer and the metal bottom layer arranged in between. The metal substrate structure further comprises at least one terminal that is coupled to the metal top layer by means of laser welding.

The at least one terminal can comprise an anti-reflection coating on a top surface of the terminal foot that is configured to face the impinging laser beam during laser welding and/or a coating on a bottom surface of the terminal foot that is configured to face the metal top layer of the metal substrate structure during laser welding.

According to a further embodiment the metal substrate structure comprises a metal spacer element that is configured to form a protrusion for the at least one terminal and that is coupled to the metal top layer. The metal spacer element is further coupled to the at least one terminal by means of laser welding with a laser beam such that a welding joint is formed between the terminal and the metal spacer element and the at least one terminal and the metal spacer element are firmly bonded. Such a protrusion can be formed by a separate element on the metal top layer and/or may be formed in one piece with the metal top layer.

According to an embodiment, a semiconductor power module for a semiconductor device comprises an embodiment of the described metal substrate structure and which is electrically interconnected with the at least one terminal of the metal substrate structure. The semiconductor power module can further comprise a heat sink which is coupled with the metal bottom layer of the metal substrate structure to dissipate heat during operation of the semiconductor power module. Thus, the semiconductor power module can comprise a separate heat sink. Alternatively or additionally, the metal bottom layer of the metal substrate structure can act as a heat sink itself and can be configured to comprise ribs or protrusion on the bottom side with respect to a stacking direction, for example, to provide a beneficial heat dissipation. The metal bottom layer can further act as a baseplate of the semiconductor power module. The semiconductor power module including the metal substrate structure can be further partly or completely encapsulated by resin prepared by molding or potting or dielectric gel. Terminals may act as power terminals or as auxiliary terminals, e.g. used for signal wiring.

Moreover, the semiconductor power module can comprise two or more embodiments of the aforementioned metal substrate structure. The electronics may include chips, integrated circuits and/or other discrete devices.

As a result of that the described metal substrate structure can be manufactured by the described embodiments of the method and as a result of that the described semiconductor power module comprises an embodiment of the metal substrate structure, described features and characteristics of the method are also disclosed with respect to the metal substrate structure and the semiconductor power module and vice versa. Thus, the present disclosure comprises several aspects, wherein every feature described with respect to one of the aspects is also disclosed herein with respect to the other aspect, even if the respective feature is not explicitly mentioned in the context of the specific aspect.

The present disclosure is related to laser welding of power and auxiliary terminals on insulated metal substrates or insulated metal baseplates, but also on substrate structures basing on alternative metal substrate structure technologies, like stamped and molded metal substrate structures. For instances, the insulated metal substrate comprises a relative thick metal base or bottom layer made of aluminum and/or copper, for example. The insulated metal substrate further comprises an isolating sheet basing on resin material which form the resin layer, and a circuit metallization made of aluminum and/or copper forming the metal top layer. The resin material used for the isolating sheet is typically a thermosetting resin containing a heat conductive inorganic filler material. This filler material mostly consists of ceramic particles prepared from aluminum nitride (AlN), silicon nitride (Si3N4), boron nitride (BN), or aluminum oxide (Al203) or silicon oxide (SiO2). The resin isolating layer can have a thickness of 100-200 µm, and the circuit metallization of the metal top layer may have a thickness of 150-500 µm.

The terminals can realize main and/or auxiliary terminals made of copper or copper alloy and are laser welded to the circuit metallization of the insulated metal substrate. Due to laser welding from the top surface of the terminal foot is irradiated by the laser beam resulting in a strong local heating. A controlled local melting of the material of the terminal foot and of the substrate surface occurs creating a very reliable joining material connection. Depending on type and material of the terminal, the terminal foot can have a thickness of 0.5-2.0 mm. For an improved welding process or a protection, e.g. against oxidation, the substrate top surface and/or the terminal foot may be coated by a metal layer, e.g. made from nickel, silver, and/or gold.

In view of the laser welding for firmly bonding the terminals to the metal top layer or the optional metal spacer element a thermal impact must be considered basically when welding terminal feet on the circuit metallization of an insulated metal substrate. Nevertheless, a thermal impact of a laser welding process creating a local melting of the terminal foot occurs and additional measures and/or features may be useful to prevent or counteract a damage of the resin layer during welding. One or more of the following features may be used for an improvement of the thermal situation during laser welding by an improved protection of the resin layer or by a reduction of the total amount of heat:
- Locally thicker substrate metallization on position of terminal foot to locally mechanically reinforce the substrate and to reduce the heat impact on the resin sheet
- Additional platelet mounted to substrate surface on terminal position to locally mechanically reinforce the substrate and to reduce the heat impact on the resin sheet
- Coating(s) of terminal and/or substrate e.g. with noble metal or other metal like nickel to prevent oxidation and make the bonding more effective
- Anti-reflective coatings of terminals to avoid the reflection of the laser and make the welding more effective with reduced power
- Thin terminal foot (completely or local) to make the welding more effective with reduced power and such that a smaller amount of material needs to be molten
- Slits or holes in terminal foot and welding on edges of slits or holes to concentrate the temperature locally (avoid lateral spreading)
- Clearance gap between terminal foot and substrate surface during welding process
- Multiple local laser welded connections

Such options can be solely applied, but also a combination of two or more of these options is possible.

The proposed process of laser welding of terminal feet on insulated metal substrates has a strong potential to reduce the mechanical impact on the resin isolating sheet significantly compared with ultrasonic welding, for example. Additionally, the thermal impact of the laser welding process can be reduced by application of one or more of the proposed features A successful welding process without damaging the heat- and pressure-sensitive resin layer is possible making the use of this comparably cost-effective substrate technology interesting. Such an attaching or manufacturing method for a metal substrate structure can be interesting for large power modules and modules even for higher voltage classes. A significant cost-down may be possible, when replacing a conventional standard setup of ceramic substrates being soldered to a baseplate by an insulated metal substrate. On the one hand material costs may be reduced, and on the other hand several process steps like the joining process between substrate and baseplate in the power module assembly are removed from the process flow. However, the described method also allows to manufacture metal substrate structures and semiconductor power modules that can be applied to miscellaneous products, especially low voltage industrial and automotive products.

Exemplary embodiments are explained in the following with the aid of schematic drawings and reference numbers. The figures show:
- Figure 1: an embodiment of a method for attaching a terminal to a metal substrate structure of semiconductor power module in a side view;
- Figure 2: a further embodiment of a method for attaching a terminal to a metal substrate structure of semiconductor power module in a side view using platelet;
- Figures 3-4: embodiments of the terminal for attaching to a metal substrate structure in a respective side view;
- Figures 5-8: embodiments of a terminal foot of a terminal in a respective top view;
- Figure 9: a flow chart for a method of attaching an embodiment of the terminal to the metal substrate structure.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in different figures, the description thereof is not repeated for each of the following figures. For the sake of clarity elements might not appear with corresponding reference symbols in all figures possibly.

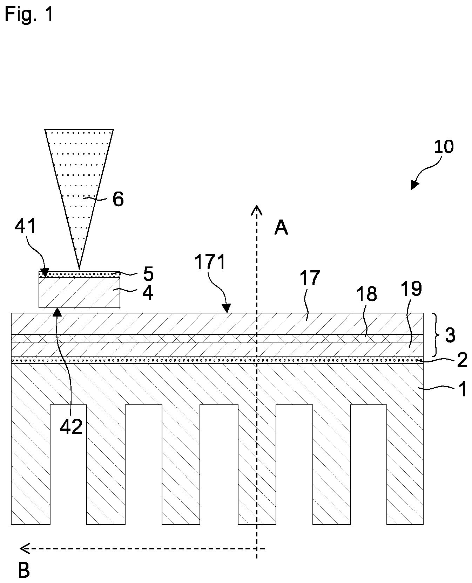

Figure 1 illustrates a side view of an embodiment of a method step for attaching a terminal 4 to a metal substrate structure 3 of a semiconductor power module 10 for a semiconductor device. The semiconductor power module 10 comprises the metal substrate structure 3 with a metal top layer 17, a metal bottom layer 19 and an isolating resin layer 18 arranged between the metal top layer 17 and the metal bottom layer 19. The electronics can include chips and power semiconductor devices, for example.

The semiconductor power module 10 further comprises a heat sink 1 with a rib structure which is coupled with the metal substrate structure 3 by means of a bonding layer 2 and/or a layer of thermal interface material. With respect to an illustrated stacking direction A the terminal 4 is to be coupled to the metal top layer 17 and underneath the heat sink 1 is coupled with the metal bottom layer 19 via the bonding layer 2.

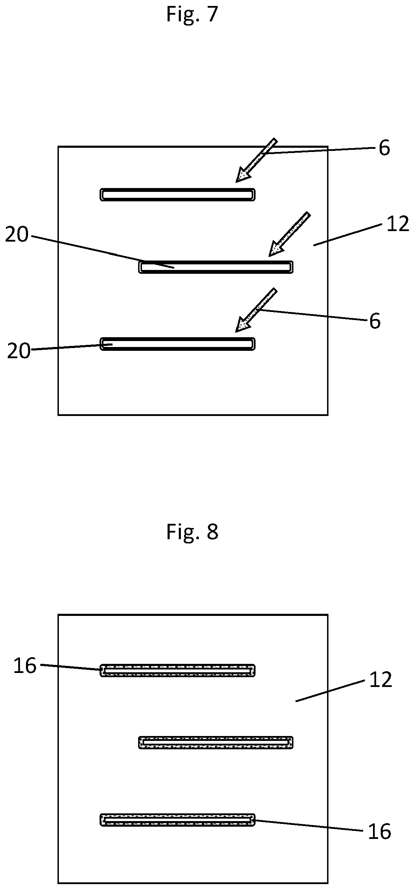

In this respect terms like "above", "under", "top", "upper" and "bottom" refer to an orientation or direction as illustrated in the figures and with respect to the staking direction A. Thus, a height or thickness of the described elements is related to the stacking direction A whereas lateral directions B and C are orientated perpendicular to the stacking direction A (see Figs. 1-8).

A thickness of the isolating resin layer 18 can be between 100-200 µm, for example. A thickness of the circuit metallization that is formed by the metal top layer 17 can be between 150-500 µm. A thickness of the metal bottom layer 19 which may realize a baseplate can be between 2-3 mm and may also be configured to dissipate heat from the metal substrate structure 3 and the semiconductor power module 10. The resin layer 18 can comprise an epoxy resin material, but also other types of resin like thermosetting or thermoplastic resin is possible. The resin layer 18 may be formed as a resin sheet or a pre-preg sheet that is assembled or laminated between the two metal layers 17, 19. Alternatively or additionally, the metal substrate structure 3 comprises the resin layer 18 formed by means of molding, for example by means of injection, transfer or compression molding. The resin of the resin layer can contain inorganic filler, ceramic material, e.g. AlN, Si3N4, BN, Al2O3 or SiO2. The metal bottom layer 19 can be made of or comprise copper and/or aluminum and/or a corresponding alloy. The circuit metallization formed by the metal top layer 17 can be made of or comprise copper and/or aluminum and/or a corresponding alloy. Moreover, the metal top layer 17 may be coated partially or completely and a corresponding coating of the circuit metallization can be made of or comprise nickel and/or gold and/or silver and/or other metals.

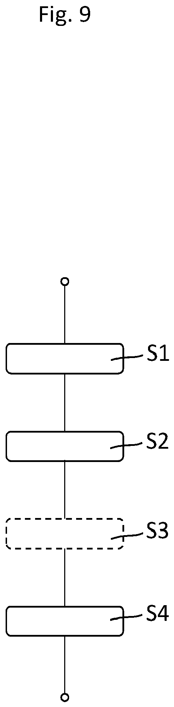

Steps of the method for attaching the terminal 4 to the metal substrate structure 3 can follow the flow chart as shown in Figure 9. Thus, according to the embodiment illustrated in Figure 1 in a step S1 at least one terminal 4 is provided. The terminal 4 be provided comprising an anti-reflection coating 5 on its top surface 41.

In a step S2 the metal substrate structure 3 is provided with the metal top layer 17, the metal bottom layer 19 and the isolating resin layer 18 arranged therebetween.

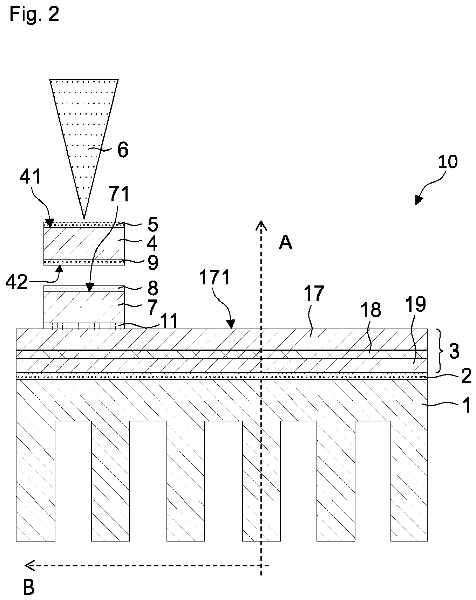

In an optional step S3 an additional metal spacer element 7 can be provided to form a protrusion for the terminal 4 on a top surface 171 of the metal top layer 17 (see Figure 2). The spacer element 7 is joined to the top metallization on terminal position.

In a further step S4 the terminal 4 is coupled to the metal top layer 17 of the metal substrate structure 3 by means of laser welding with a laser beam 6 such that a welding joint 16 between the terminal 4 and the metal top layer 17 is formed and the terminal 4 and the metal top layer 17 are firmly bonded. The anti-reflection coating 5 partially or completely covers the top surface 41 of the terminal 4 facing the impinging laser beam 6 and improves the laser welding process.

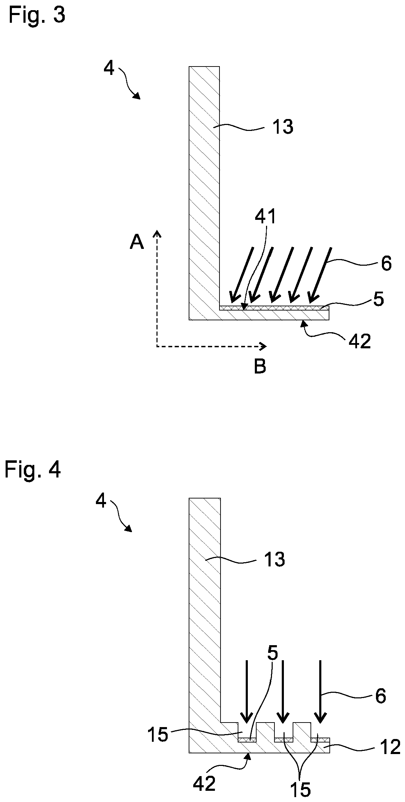

The terminal 4 can be provided comprising an L-shape with respect to a side view as illustrated in the Figs. 3 and 4. Thus, the terminal 4 comprises a terminal body 13 and a terminal foot 12 made form one piece or separate pieces. The terminal foot 12 is configured to be coupled with the metal top layer 17 and can be provided to comprise a structure prepared for laser welding with one or more of a thinned area (see Figure 3) and/or a slot, a groove 20 and/or a recess 15 (see Figures 4-8). Such structures can be real openings or only recessed parts and/or thinned portions.

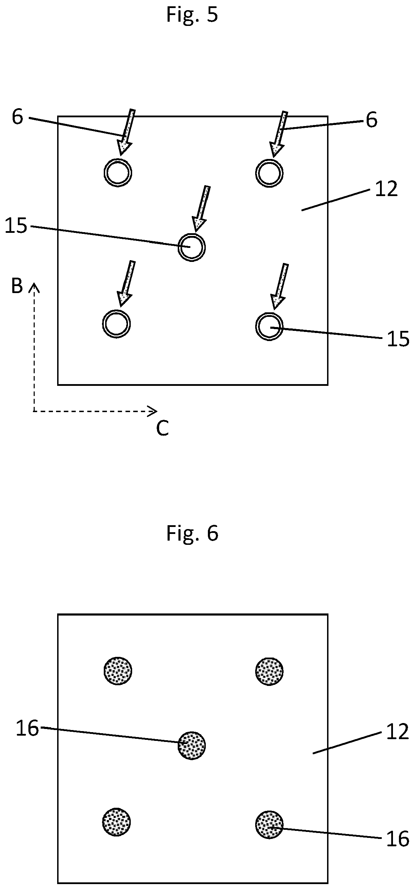

Such modifications of the terminal foot 12 can contribute to an improved laser welding process and the attachment of the terminal to the metal substrate structure 3. Moreover, thermal stress that affects the resin layer 18 is reduced. The terminal foot 12 can comprise a completely reduced thickness or a welding area with reduced thickness smaller than a thickness of the vertical terminal body 13 of terminal 4. Alternatively or additionally, one or more grooves 20 or other local recessed portions 15 can beneficially influence the laser welding process that is performed on a bottom of such recessed openings (see Figs. 4-8). This also applies to an implementation of holes or slots and laser welding can be performed on edges of such holes or slots 20, for example directly at the interface between terminal foot 12 and the metallization. The laser welding process can also be performed on multiple small local spots on the terminal foot 12 as indicated in the Figs. 5 and 6. This can also apply to a thinned terminal foot 12 such that multiple local welding spots are formed.

The terminal 4 can be made of or comprise copper and/or copper alloy and may realize a main or an auxiliary terminal for electrically connection to electronics of the semiconductor power module 10. The terminal foot 12 can comprise a thickness with respect to the stacking direction A of 1 mm, 1.5 mm or 2 mm. The terminal foot 12 can be a partially or completely thinned comprising a thickness of 0.5 mm or less. Thus, the terminal foot 12 can comprise a thickness between 0.5-2 mm. If there is a locally thinned portion, this portion may have a thickness of at least 0.25 mm. Moreover, the terminal 4 can comprise a terminal coating layer 9 which partially or completely covers a bottom surface 42 of terminal foot 12. The terminal coating layer 9 can beneficially affect the laser welding process and may be made of or comprise nickel, gold, silver and/or other metals. Such a coating may also be useful for attaching the terminal 4 in combination with the additional metal spacer element 7 (see Fig. 2).

If such an additional spacer is provided the method for attaching the terminal 4 comprises coupling the metal spacer element 7 to the metal top layer 17 of the metal substrate structure 3, and coupling the terminal 4 to the metal spacer element 7 by means of laser welding with the laser beam 6 such that a welding joint 16 between the terminal 4 and the metal spacer element 7 is formed and the terminal 4 and the metal spacer element 7 are firmly bonded.

The arrangement of the metal spacer element 7, for example in form of a metal block or spring structure, between circuit metallization of the metal top layer 17 and the terminal 4 also enables improvement of the laser welding process and protection for the resin layer 18. The metal spacer element 7 may have a thickness of 0.5 mm up to 2.0 mm. The metal spacer element 7 can be manufactured via a stamping tool, for example. Alternatively or additionally to the separate metal spacer element 7 the circuit metallization of the metal top layer 17 can comprise a locally enhanced thickness itself which is intentionally formed with a height of up to 2.0 mm with respect to the stacking direction A and adjacent areas of the metal top layer 17. Such a protrusion is formed on a position of the metal top layer 17 the terminal 4 is going to be attached to.

The metal spacer element 7 can be made of or comprise copper and/or copper alloy. A spacer coating layer 8 can be arranged on an upper or top surface 71 of the metal spacer element 7 which partially or completely covers the top surface 71. Alternatively or additionally, a coating may be present on the bottom surface of the spacer element 7.

The spacer coating layer can be made of or comprise nickel, gold, silver and/or other metals. The metal spacer element 7 can be connected to the top surface 171 of the metal top layer 17 by means of soldering, sintering, gluing and/or another applicable joining method.

Moreover, the laser welding process can be configured to provide specific parameters to beneficially affect the formation of the one or more welding joints 16. Thus, a laser power of the laser beam 6 can be between 300-3000 W. A velocity of a laser spot of the laser beam 6 on the top surface 41 of the terminal 4 can be between 1-200 mm/s. An oscillation frequency of the laser spot to provide wobbling can be 2 kHz or lower. Such a wobbling may present an oscillation of location of point of irradiation to prevent too strong local heating and may occur in addition to the laser movement mentioned above.

Furthermore, a setup for attaching the terminal 4 to the metal substrate structure 3 can be configured to prepare a direct contact between the terminal 4 and the metal top layer 17 or the metal spacer element 7. Alternatively, there can be set a predetermined gap of up to 500 µm with respect to the stacking direction between joining the aforementioned joining partners. The latter, can realize a further beneficial configuration for an improved positioning of the terminal 4 and a protection of the insulated metal substrate structure 3 against heat. The terminal foot 12 will be kept in position, whereas a laser welded joining connection is provided by drops and/or deformation of molten material from the terminal foot 12.

The described embodiments of the method for attaching the terminal and/or manufacturing the metal substrate structure 3 with one or more attached terminals 4 enable to reduce a risk of crack or damage formation in the resin layer. Thus, due to the method a stable semiconductor power module 10 is feasible that enables reliable functioning even for high voltage power module applications in a voltage range of 0.5 kV up to 10.0 kV, for example.

The embodiments shown in the Figures 1 to 9 as stated represent exemplary embodiments of the improved metal substrate structure 3, the semiconductor power module 10 and the manufacturing method for; therefore, they do not constitute a complete list of all embodiments. Actual arrangements and methods may vary from the embodiments shown in terms of metal substrate structures 3 and semiconductor power modules 10, for example.

### Reference signs

- 1: heat sink
- 2: bonding layer
- 3: metal substrate structure
- 4: terminal
- 41: top surface of the terminal
- 42: bottom surface of the terminal
- 5: anti-reflection coating
- 6: laser beam
- 7: metal spacer element
- 71: top surface of the metal spacer element
- 8: spacer coating layer
- 9: terminal coating layer
- 10: semiconductor power module
- 11: joining layer
- 12: terminal foot
- 13: terminal body
- 14: foot structure
- 15: recess
- 16: welding joint
- 17: metal top layer
- 171: top surface of the metal top layer
- 18: resin layer
- 19: metal bottom layer
- 20: slot / groove

- A: stacking direction
- B: lateral direction
- C: lateral direction
- S(i): steps of a method for manufacturing a metal substrate structure for a semiconductor power module

## Claims

1. A method for attaching a terminal (4) to a metal substrate structure (3) for a semiconductor power module (10), comprising:
- providing at least one terminal (4),
- providing the metal substrate structure (3) with a metal top layer (17), a metal bottom layer (19) and an isolating resin layer (18) arranged between the metal top layer (17) and the metal bottom layer (19), and
- coupling the at least one terminal (4) to the metal top layer (17) of the metal substrate structure (3) by means of laser welding with a laser beam (6).

2. The method according to claim 1, wherein at least one of the metal substrate structure (3) and the at least one terminal (4) is provided with a structure prepared for laser welding with at least one of a thinned area, a slot, a groove (20), a hole, a coating (5, 8, 9), an opening and a recess (15) such that coupling the at least one terminal (4) to the metal top layer (17) of the metal substrate structure (3) by means of laser welding is controlled to form at least one welding joint (16) and to minimize the thermal impact on the isolating resin layer (18).

3. The method according to claim 1 or 2, wherein the step of providing the at least one terminal (4) comprises:
providing the at least one terminal (4) with at least one of an anti-reflection coating (5) on a top surface (41) that is configured to face the impinging laser beam (6) during laser welding and a coating (9) on a bottom surface (42) that is configured to face the metal top layer (17) of the metal substrate structure (3) during laser welding.

4. The method according to one of the preceding claims, wherein the step of coupling the at least one terminal (4) to the metal substrate structure (3) by means of laser welding comprises:
- aligning the terminal (4) and the metal substrate structure (3) relative to each other such that a top surface (171) of the metal top layer (17) contacts a bottom surface (42) of the terminal (4) facing each other, and
- laser welding the terminal (4) with the laser beam (6) such that a welding joint (16) between the terminal (4) and the metal substrate structure (3) is formed and the at least one terminal (4) and the metal top layer (17) are firmly bonded.

5. The method according to one of the claims 1 to 3, wherein the step of coupling the at least one terminal (4) to the metal substrate structure (3) by means of laser welding comprises:
- aligning the terminal (4) and the metal substrate structure (3) relative to each other with a predetermined distance in between defining a gap of up to 500 µm between a top surface (171) of the metal top layer (17) and a bottom surface (42) of the terminal (4) facing each other, and
- laser welding the terminal (4) with the laser beam such that the terminal (4) locally melts and a welding joint (16) between the terminal (4) and the metal substrate structure (3) is formed by means of dropping or running or deformation of molted terminal material and the at least one terminal (4) and the metal top layer (17) are firmly bonded.

6. The method according to one of the preceding claims, wherein the step of providing the metal substrate structure (3) comprises:
providing the metal top layer (17) with at least one protrusion with given a local enhanced thickness that is 0.5 mm up to 2.0 mm thicker than an adjacent area of the metal top layer (17) and that is formed at a position on a top surface (171) of the metal top layer (17) that is configured to be coupled to the at least one terminal (4).

7. The method according to one of the preceding claims, comprising:
- providing a metal spacer element (7) configured to form a protrusion for the at least one terminal (4),
- coupling the metal spacer element (7) to the metal top layer (17) of the metal substrate structure (3), and
- coupling the at least one terminal (4) to the metal spacer element (7) by means of laser welding with a laser beam (6) such that a welding joint (16) between the terminal (4) and the metal spacer element (7) is formed and the at least one terminal (4) and the metal spacer element (7) are firmly bonded.

8. The method according to claim 7, wherein the step of providing the metal spacer element (7) comprises:
providing the metal spacer element (7) with a coating layer (8) on a top surface (71) that is configured to face a bottom surface (42) of the at least one terminal (4) during laser welding and/or with a coating layer on a bottom surface that is configured to face a top surface (171) of the metal top layer (17) during laser welding.

9. The method according to claim 7 or 8, wherein the metal spacer element (7) is provided in form of one of a block and a spring with a thickness of 0.5 mm up to 2.0 mm with respect to a stacking direction (A) of the metal substrate structure (3) and the at least one terminal (4).

10. The method according to one of the claims 7-9, wherein the metal spacer element (7) is coupled to the metal top layer (17) by means of at least one of soldering, sintering and gluing.

11. The method according to one of the claims 7-10, wherein the step of providing the at least one terminal (4) comprises:
providing the at least one terminal (4) with a terminal foot (12) that is configured to be coupled with the metal top layer (17), wherein the terminal foot (12) comprises a structure prepared for laser welding with at least one of a thinned area, a slit, a groove (20), a hole, an opening and a recess (15).

12. The method according to claim 11, wherein the laser welding is done in the thinned area and/or in the groove (20) and/or in the recess (15) and/or on an edge of the hole and/or on an edge of the slit.

13. A semiconductor power module (10), comprising:
- metal substrate structure (3) with a metal top layer (17), a metal bottom layer (19), and an isolating resin layer (18) that is coupled with both the metal top layer (17) and the metal bottom layer (19) in between, and
- at least one terminal (4) that is coupled to the metal top layer (17) by means of laser welding.

14. The semiconductor power module (10) according to claim 13, wherein the at least one terminal (4) comprises at least one of an anti-reflection coating (5) on a top surface (41) that is configured to face the impinging laser beam (6) during laser welding and a coating (9) on a bottom surface (42) that is configured to face the metal top layer (17) of the metal substrate structure (3) during laser welding.

15. The semiconductor power module (10) according to claim 13 or 14, comprising:
a metal spacer element (7) that is configured to form a protrusion for the at least one terminal (4) and that is coupled to the metal top layer (17), and that is coupled to the at least one terminal (4) by means of laser welding with a laser beam (6) such that a welding joint (16) is formed between the terminal (4) and the metal spacer element (7) and the at least one terminal (4) and the metal spacer element (7) are firmly bonded.

## Amended claims

### Amended claims in accordance with Rule 137(2) EPC.

1. A method for attaching a terminal (4) to a metal substrate structure (3) for a semiconductor power module (10), comprising:
- providing at least one terminal (4),
- providing the metal substrate structure (3) with a metal top layer (17), a metal bottom layer (19) and an isolating resin layer (18) arranged between the metal top layer (17) and the metal bottom layer (19), wherein the metal top layer (17) is made from one piece with at least one protrusion with a given local enhanced thickness that is 0.5 mm up to 2.0 mm thicker than an adjacent area of the metal top layer (17) and that is formed at a position on a top surface (171) of the metal top layer (17) configured to be coupled to the at least one terminal (4), and
- coupling the at least one terminal (4) to the protrusion of the metal top layer (17) of the metal substrate structure (3) by means of laser welding with a laser beam (6) .

2. The method according to claim 1, wherein at least one of the metal substrate structure (3) and the at least one terminal (4) is provided with a structure prepared for laser welding with at least one of a thinned area, a slot, a groove (20), a hole, a coating (5, 8, 9), an opening and a recess (15) such that coupling the at least one terminal (4) to the metal top layer (17) of the metal substrate structure (3) by means of laser welding is controlled to form at least one welding joint (16) and to minimize the thermal impact on the isolating resin layer (18).

3. The method according to claim 1 or 2, wherein the step of providing the at least one terminal (4) comprises:
providing the at least one terminal (4) with at least one of an anti-reflection coating (5) on a top surface (41) that is configured to face the impinging laser beam (6) during laser welding and a coating (9) on a bottom surface (42) that is configured to face the metal top layer (17) of the metal substrate structure (3) during laser welding.

4. The method according to one of the preceding claims, wherein the step of coupling the at least one terminal (4) to the metal substrate structure (3) by means of laser welding comprises:
- aligning the terminal (4) and the metal substrate structure (3) relative to each other such that a top surface (171) of the metal top layer (17) contacts a bottom surface (42) of the terminal (4) facing each other, and
- laser welding the terminal (4) with the laser beam (6) such that a welding joint (16) between the terminal (4) and the metal substrate structure (3) is formed and the at least one terminal (4) and the metal top layer (17) are firmly bonded.

5. The method according to one of the claims 1 to 3, wherein the step of coupling the at least one terminal (4) to the metal substrate structure (3) by means of laser welding comprises:
- aligning the terminal (4) and the metal substrate structure (3) relative to each other with a predetermined distance in between defining a gap of up to 500 µm between a top surface (171) of the metal top layer (17) and a bottom surface (42) of the terminal (4) facing each other, and
- laser welding the terminal (4) with the laser beam such that the terminal (4) locally melts and a welding joint (16) between the terminal (4) and the metal substrate structure (3) is formed by means of dropping or running or deformation of molted terminal material and the at least one terminal (4) and the metal top layer (17) are firmly bonded.

6. The method according to one of the preceding claims, comprising:
- providing a metal spacer element (7) configured to form a protrusion for the at least one terminal (4),
- coupling the metal spacer element (7) to the metal top layer (17) of the metal substrate structure (3), and
- coupling the at least one terminal (4) to the metal spacer element (7) by means of laser welding with a laser beam (6) such that a welding joint (16) between the terminal (4) and the metal spacer element (7) is formed and the at least one terminal (4) and the metal spacer element (7) are firmly bonded.

7. The method according to claim 6, wherein the step of providing the metal spacer element (7) comprises:
providing the metal spacer element (7) with a coating layer (8) on a top surface (71) that is configured to face a bottom surface (42) of the at least one terminal (4) during laser welding and/or with a coating layer on a bottom surface that is configured to face a top surface (171) of the metal top layer (17) during laser welding.

8. The method according to claim 6 or 7, wherein the metal spacer element (7) is provided in form of one of a block and a spring with a thickness of 0.5 mm up to 2.0 mm with respect to a stacking direction (A) of the metal substrate structure (3) and the at least one terminal (4).

9. The method according to one of the claims 6-8, wherein the metal spacer element (7) is coupled to the metal top layer (17) by means of at least one of soldering, sintering and gluing.

10. The method according to one of the claims 6-9, wherein the step of providing the at least one terminal (4) comprises:
providing the at least one terminal (4) with a terminal foot (12) that is configured to be coupled with the metal top layer (17), wherein the terminal foot (12) comprises a structure prepared for laser welding with at least one of a thinned area, a slit, a groove (20), a hole, an opening and a recess (15).

11. The method according to claim 10, wherein the laser welding is done in the thinned area and/or in the groove (20) and/or in the recess (15) and/or on an edge of the hole and/or on an edge of the slit.

12. A semiconductor power module (10), comprising:
- metal substrate structure (3) with a metal top layer (17), a metal bottom layer (19), and an isolating resin layer (18) that is coupled with both the metal top layer (17) and the metal bottom layer (19) in between, wherein the metal top layer (17) is made from one piece with at least one protrusion with a given local enhanced thickness that is 0.5 mm up to 2.0 mm thicker than an adjacent area of the metal top layer (17) and that is formed at a position on a top surface (171) of the metal top layer (17), and
- at least one terminal (4) that is coupled to the protrusion of the metal top layer (17) by means of laser welding.

13. The semiconductor power module (10) according to claim 12, wherein the at least one terminal (4) comprises at least one of an anti-reflection coating (5) on a top surface (41) that is configured to face the impinging laser beam (6) during laser welding and a coating (9) on a bottom surface (42) that is configured to face the metal top layer (17) of the metal substrate structure (3) during laser welding.

14. The semiconductor power module (10) according to claim 12 or 13, comprising:
a metal spacer element (7) that is configured to form a protrusion for the at least one terminal (4) and that is coupled to the metal top layer (17), and that is coupled to the at least one terminal (4) by means of laser welding with a laser beam (6) such that a welding joint (16) is formed between the terminal (4) and the metal spacer element (7) and the at least one terminal (4) and the metal spacer element (7) are firmly bonded.
